# EUROPEAN PATENT APPLICATION

(11) **EP 4 465 360 A1**
(43) Date of publication of application: **20.11.2024**
(21) Application number: 23859082.2
(22) Date of filing: 08.08.2023
(51) Int. Cl.: H01L 27/148

(54) **DISPLAY SUBSTRATE AND DISPLAY APPARATUS**

(30) Priority: 31.08.2022 CN 202211059440
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: LI, De, Beijing 100176 (CN); LI, Zhengkun, Beijing 100176 (CN); LONG, Yue, Beijing 100176 (CN); ZHANG, Bo, Beijing 100176 (CN)
(74) Representative: Brötz, Helmut
(86) International application number: PCT/CN2023/111616
(87) International publication number: WO 2024/046047

(57) **Abstract**

A display substrate (100) and a display apparatus (300). In the display substrate (100), a plurality of data lines (130) are configured to provide data signals for a plurality of pixel driving columns (220); and the plurality of pixel driving columns (220) comprise a plurality of first pixel driving columns (220A) and a plurality of second pixel driving columns (220B), wherein pixel driving circuits (120) in the first pixel driving columns (220A) are connected to a first light-emitting element (151) in a normal display area (114), and some of pixel driving circuits (120) in the second pixel driving columns (220B) are connected to a second light-emitting element (152) in a transparent display area (112) by means of a plurality of anode connection lines (140). The display substrate (100) further comprises a first adapter cable (171) and a second adapter cable (172), wherein the first adapter line (171) and the second adapter line (172) are connected to a cathode of the first light-emitting element (151), and transmit a first power source voltage; the first adapter line (171) and the second adapter line (172) are connected by means of a first via hole connection structure (V1); and the orthographic projection of the first via hole connection structure (V1) on a base substrate (110) does not overlap with the orthographic projections of the plurality of anode connection lines (140) on the base substrate (110). Thus, the display substrate (100) can improve the display image quality, and can also reduce the risk of breakage of the anode connection lines (140).

## Description

### CROSS-REFERENCE TO RELATED APPLICATION

The present application claims priority of the Chinese Patent Applications No. 202211059440.5 filed on August 31, 2022, the content of which is incorporated as a part of the present application.

### TECHNICAL FIELD

Embodiments of the present disclosure relates to a display substrate and a display apparatus.

### BACKGROUND

With the continuous development of display technology, people have higher and higher requirements for the screen ratio of electronic products such as smartphones. Therefore, full display with camera (FDC) design has gradually become a research hotspot for major manufacturers.

The full display with camera design is to arrange a transparent display region in the display region of the display panel, the transparent display region can perform display and allow light to pass through; the transparent display region of the display panel is provided with a photosensitive device such as a camera, so that a large screen ratio can be achieved, and at the same time, taking photos, face recognition and other functions can be realized.

### SUMMARY

On the basis of achieving the full display with camera design and narrow frame, in order to further reduce the load on the power voltage (VSS) and improve the image quality, the embodiments of the present disclosure provide a display substrate and a display apparatus. The display apparatus includes a base substrate, a plurality of pixel driving circuits, a plurality of data lines, and a plurality of anode connection lines; the base substrate includes a transparent display region and a normal display region surrounding the transparent display region; the plurality of pixel driving circuits are located in the normal display region and arranged in an array along a first direction and a second direction to form a plurality of pixel driving rows and a plurality of pixel driving columns, each of the plurality of pixel driving rows extends in the first direction, each of the plurality of pixel driving columns extends in the second direction; the plurality of data lines extend in the second direction and are configured to provide data signals to the plurality of pixel driving columns; the normal display region includes a first light emitting element, the transparent display region includes a second light emitting element, the plurality of pixel driving columns includes a plurality of first pixel driving columns and a plurality of second pixel driving columns, and pixel driving circuits in each of the plurality of first pixel driving columns each is connected with the first light emitting element, and a part of pixel driving circuits in each of the plurality of second pixel driving columns each is connected with the second light emitting element through one of the plurality of anode connection lines; the display substrate further includes a first transfer line and a second transfer line, the first transfer line extends in the first direction, the second transfer line extends in the second direction, the first transfer line and the second transfer line are arranged in different layers, and the first transfer line and the second transfer line are connected with a cathode of the first light emitting element and are configured to transmit a first power voltage, the first transfer line is connected with the second transfer line through a first via hole connection structure, and an orthographic projection of the first via hole connection structure on the base substrate does not overlap with an orthographic projection of the plurality of anode connection lines on the base substrate. Therefore, the display substrate can reduce the load of the signal line configured to transmit the first power voltage and improve the display image quality under the premise of achieving the full display with camera design. On the other hand, the display substrate can further reduce the risk of disconnection of the anode connection line.

At least one embodiment of the present disclosure provides a display substrate, which includes: a base substrate, comprising a transparent display region and a normal display region surrounding the transparent display region; a plurality of pixel driving circuits, located in the normal display region and arranged in an array along a first direction and a second direction to form a plurality of pixel driving rows and a plurality of pixel driving columns, each of the plurality of pixel driving rows extending in the first direction, each of the plurality of pixel driving columns extending in the second direction; a plurality of data lines, extending in the second direction and configured to provide data signals to the plurality of pixel driving columns; a plurality of anode connection lines, the normal display region comprises a first light emitting element, the transparent display region comprises a second light emitting element, the plurality of pixel driving columns comprises a plurality of first pixel driving columns and a plurality of second pixel driving columns, and pixel driving circuits in each of the plurality of first pixel driving columns each is connected with the first light emitting element, and a part of pixel driving circuits in each of the plurality of second pixel driving columns each is connected with the second light emitting element through one of the plurality of anode connection lines; the display substrate further comprises a first transfer line and a second transfer line, the first transfer line extends in the first direction, the second transfer line extends in the second direction, the first transfer line and the second transfer line are arranged in different layers, and the first transfer line and the second transfer line are connected with a cathode of the first light emitting element and are configured to transmit a first power voltage, the first transfer line is connected with the second transfer line through a first via hole connection structure, and an orthographic projection of the first via hole connection structure on the base substrate does not overlap with an orthographic projection of the plurality of anode connection lines on the base substrate.

For example, in the display substrate provided by an embodiment of the present disclosure, the display substrate further comprises a third transfer line and a fourth transfer line, the third transfer line and the fourth transfer line are located in the normal display region, the third transfer line extends in the first direction, and the fourth transfer line extends in the second direction, one end of the third transfer line is connected with the data line, and the other end of the third transfer line is connected with the fourth transfer line.

For example, in the display substrate provided by an embodiment of the present disclosure, the third transfer line and the first transfer line are arranged in the same layer.

For example, in the display substrate provided by an embodiment of the present disclosure, the fourth transfer line and the second transfer line are arranged in the same layer.

For example, in the display substrate provided by an embodiment of the present disclosure, the display substrate further includes: a connection line segment, arranged in the same layer as the third transfer line and insulated with the third transfer line, both of the connection line segment and the third transfer line overlap with a virtual straight line extending in the first direction, and the connection line segment connects a plurality of second transfer lines arranged in the first direction.

For example, in the display substrate provided by an embodiment of the present disclosure, in at least one of the plurality of pixel driving columns, both of the second transfer line and the fourth transfer line overlap with a virtual straight line extending in the second direction, and the second transfer line and the fourth transfer line are insulated from each other.

For example, in the display substrate provided by an embodiment of the present disclosure, the normal display region comprises a first sub-display region and a second sub-display region arranged in the first direction, the data line located at an edge of the first sub-display region is connected with the fourth transfer line located in the first sub-display region through the third transfer line, and the data line located at an edge of the second sub-display region is connected with the fourth transfer line located in the second sub-display region through the third transfer line.

For example, in the display substrate provided by an embodiment of the present disclosure, two first pixel driving columns are arranged between two adjacent second pixel driving columns.

For example, in the display substrate provided by an embodiment of the present disclosure, the plurality of data lines comprise a first data line and a second data line, and the first data line is connected with one of the plurality of first pixel driving columns and is disconnected in the transparent display region to form a first sub-data line segment and a second sub-data line segment, the second data line is connected with one of the plurality of second pixel driving columns and comprises a third sub-data line segment and a fourth sub-data line segment, an orthographic projection of the third sub-data line segment on a reference straight line extending in the second direction covers an orthographic projection of the transparent display region on the reference straight line, the display substrate further comprises a fifth transfer line and a sixth transfer line, the fifth transfer line is located at a first side of the transparent display region in the second direction, the sixth transfer line is located at a second side of the transparent display region in the second direction, the first sub-data line is connected with the third sub-data line segment through the fifth transfer line, and the second sub-data line is connected with the third sub-data line segment through the sixth transfer line.

For example, in the display substrate provided by an embodiment of the present disclosure, the fifth transfer line and the sixth transfer line are arranged in the same layer as the first transfer line.

For example, in the display substrate provided by an embodiment of the present disclosure, the fourth sub-data line segment is connected with the first transfer line through a second via hole connection structure.

For example, in the display substrate provided by an embodiment of the present disclosure, the base substrate further comprises a peripheral region surrounding the normal display region, and the fifth transfer line is located in the peripheral region.

For example, the display substrate provided by an embodiment of the present disclosure further includes: a plurality of power lines, extending in the second direction and configured to provide a second power voltage to the plurality of pixel driving columns; and a first conductive structure, arranged in the same layer as the plurality of power lines, an orthographic projection of the first conductive structure on the base substrate overlaps with an orthographic projection of a pixel driving circuit in one of the plurality of second pixel driving columns that is not connected with the plurality of anode connection lines on the base substrate, the first conductive structure is connected with the first transfer line through a third via hole connection structure.

For example, in the display substrate provided by an embodiment of the present disclosure, each of the plurality of pixel driving circuits comprises a second conductive structure arranged in the same layer as the first transfer line; the second conductive structure in the pixel driving circuit in the second pixel driving column that is not connected with the anode connection line is connected with the second transfer line through a fourth via hole connection structure.

For example, in the display substrate provided by an embodiment of the present disclosure, the base substrate further comprises a peripheral region surrounding the normal display region, and the display substrate further comprises a power voltage line located in the peripheral region, the power voltage line is configured to transmit the first power voltage; at least one of the first transfer line and the second transfer line extends to the peripheral region and is electrically connected with the power voltage line.

At least one embodiment of the present disclosure further provides a display apparatus, which includes any one of the abovementioned display substrates.

### BRIEF DESCRIPTION OF DRAWINGS

In order to more clearly explain the technical solution of the embodiments of the present disclosure, the accompanying drawings of the embodiments will be briefly introduced below. Obviously, the accompanying drawings in the following description only relate to some embodiments of the present disclosure, and are not limited to the present disclosure.
FIG. 1 is a schematic plan view of a display substrate provided by an embodiment of the present disclosure;
FIG. 2 is a schematic diagram of the connection between a first transfer line and a second transfer line in a display substrate provided by an embodiment of the present disclosure;
FIG. 3 is a schematic plan view of another display substrate provided by an embodiment of the present disclosure;
FIG. 4 is a schematic plan view of another display substrate provided by an embodiment of the present disclosure;
FIG. 5 is a schematic plan view of another display substrate provided by an embodiment of the present disclosure;
FIG. 6 is a schematic diagram of a stacked structure of a display substrate provided by an embodiment of the present disclosure;
FIG. 7A is a schematic diagram of a stacked structure of another display substrate provided by an embodiment of the present disclosure;
FIG. 7B is a schematic diagram of a stacked structure of another display substrate provided by an embodiment of the present disclosure;
FIG. 8 is a schematic diagram of a display apparatus provided by an embodiment of the present disclosure;
FIG. 9 is a schematic diagram of a stacked structure of a display substrate provided by an embodiment of the present disclosure;
FIG. 10 is an equivalent schematic diagram of a pixel driving circuit in a display substrate provided by an embodiment of the present disclosure; and
FIG. 11-FIG. 16 are schematic diagrams of a plurality of film layers in a display substrate provided by an embodiment of the present disclosure.

### DETAILED DESCRIPTION

In order to make the purpose, technical solution and advantages of the embodiment of the disclosure clearer, the technical solution of the embodiment of the disclosure will be described clearly and completely with the accompanying drawings. Obviously, the described embodiment is a part of the embodiment of the present disclosure, not the whole embodiments. Based on the described embodiments of the present disclosure, all other embodiments obtained by ordinary skilled in the field without creative labor belong to the scope of protection of the present disclosure.

Unless otherwise defined, technical terms or scientific terms used in present disclosure shall have their ordinary meanings as understood by people with ordinary skills in the field to which present disclosure belongs. The terms "first", "second" and the like used in present disclosure do not indicate any order, quantity or importance, but are only used to distinguish different components. Similar words such as "including" or "comprising" mean that the elements or objects appearing before the word cover the elements or objects listed after the word and their equivalents, without excluding other elements or objects. Similar words such as "connected" or "connected" are not limited to physical or mechanical connection, but may include electrical connection, whether direct or indirect.

Generally, a pixel unit includes a pixel driving circuit and a light emitting element connected with the pixel driving circuit, and the pixel driving circuit is usually opaque. Therefore, in full display with camera design, the transparent display region of the display substrate can achieve a transparent display function by removing the pixel driving circuit and retaining the light emitting element, that is, the transparent display region can perform display and allow light to pass through. In this technical solution, the pixel driving circuit corresponding to the light emitting element in the transparent display region needs to be arranged in the normal display region outside the transparent display region.

On the other hand, the display region of a conventional display substrate includes a plurality of signal lines for driving pixel units in the display substrate to perform light emitting display, and these signal lines require external driving circuits or driving chips for driving. Therefore, the display substrate further includes a leading line region and a bonding region located in the peripheral region, the leading line region includes a plurality of leading lines, and the bonding region is configured to bond with an external driving circuit or driving chip; in this case, the plurality of leading lines may be connected with the plurality of signal lines and extend to the bonding region to be bound to the external driving circuit or driving chip. Obviously, the existence of the leading line region and the bonding region in the peripheral region of the display substrate will inevitably affect the frame width of the display apparatus adopting the display substrate, especially the width of the lower frame. Therefore, in order to narrow the lower frame of the display apparatus, the leading lines of signal lines such as the data lines can be arranged in the display region to reduce the size of the leading line region (Fan-out region) to achieve a narrow frame design.

Based on the above technical solution, in order to further reduce the load on the power voltage (VSS) and improve the image quality, the embodiments of the present disclosure provide a display substrate and a display apparatus. The display apparatus includes a base substrate, a plurality of pixel driving circuits, a plurality of data lines, and a plurality of anode connection lines; the base substrate includes a transparent display region and a normal display region surrounding the transparent display region; the plurality of pixel driving circuits are located in the normal display region and arranged in an array along a first direction and a second direction to form a plurality of pixel driving rows and a plurality of pixel driving columns, each of the plurality of pixel driving rows extends in the first direction, each of the plurality of pixel driving columns extends in the second direction; the plurality of data lines extend in the second direction and are configured to provide data signals to the plurality of pixel driving columns; the normal display region includes a first light emitting element, the transparent display region includes a second light emitting element, the plurality of pixel driving columns includes a plurality of first pixel driving columns and a plurality of second pixel driving columns, and pixel driving circuits in each of the plurality of first pixel driving columns each is connected with the first light emitting element, and a part of pixel driving circuits in each of the plurality of second pixel driving columns each is connected with the second light emitting element through one the plurality of anode connection lines; the display substrate further includes a first transfer line and a second transfer line, the first transfer line extends in the first direction, the second transfer line extends in the second direction, the first transfer line and the second transfer line are arranged in different layers, and the first transfer line and the second transfer line are connected with a cathode of the first light emitting element and are configured to transmit a first power voltage, the first transfer line is connected with the second transfer line through a first via hole connection structure, and an orthographic projection of the first via hole connection structure on the base substrate does not overlap with an orthographic projection of the plurality of anode connection lines on the base substrate. Therefore, the display substrate can reduce the load of the signal line configured to transmit the first power voltage and improve the display image quality under the premise of achieving the full display with camera design. On the other hand, the display substrate can further reduce the risk of disconnection of the anode connection line.

Hereinafter, the display substrate and display apparatus provided by the embodiments of the present disclosure will be described in detail with reference to the accompanying drawings.

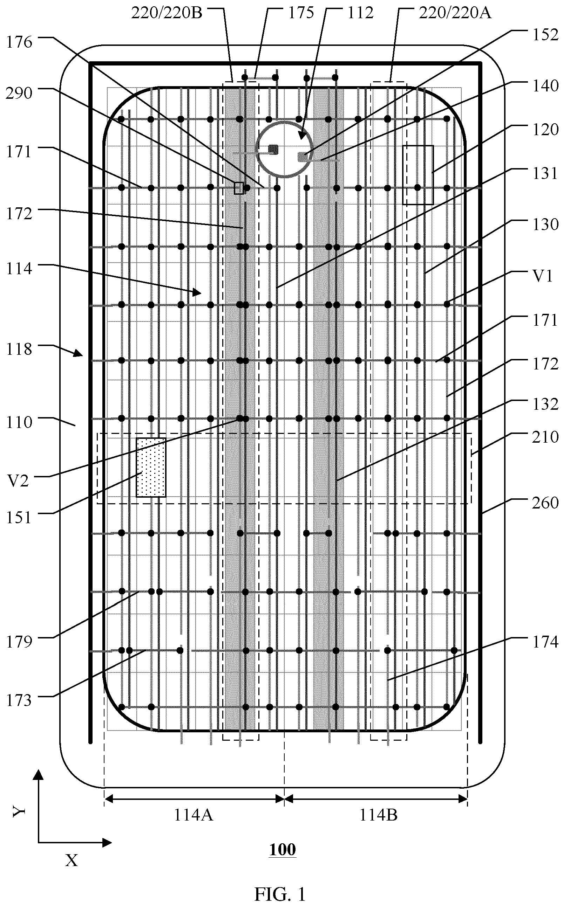

An embodiment of the present disclosure provides a display substrate. FIG. 1 is a schematic plan view of a display substrate provided by an embodiment of the present disclosure. As illustrated by FIG. 1, the display substrate 100 includes a base substrate 110, a plurality of pixel driving circuits 120, a plurality of data lines 130 and a plurality of anode connection lines 140; the base substrate 110 includes a transparent display region 112 and a normal display region 114 surrounding the transparent display region 112; the transparent display region 112 and the normal display region 114 may constitute a display region for light emitting display. The plurality of pixel driving circuits 120 are located in the normal display region 114 and are arranged in an array along a first direction X and a second direction Y to form a plurality of pixel driving rows 210 and a plurality of pixel driving columns 220, each of the plurality of pixel driving rows 210 extends in the first direction X, each of the plurality of pixel driving columns 220 extends in the second direction Y; the plurality of data lines 130 extend in the second direction Y and are configured to provide data signals to the plurality of pixel driving columns 220.

As illustrated by FIG. 1, the normal display region 114 includes a first light emitting element 151, the transparent display region 112 includes a second light emitting element 152, and the plurality of pixel driving columns 220 includes a plurality of first pixel driving columns 220A and a plurality of second pixel driving columns 220B; the pixel driving circuits 120 in each of the plurality of first pixel driving columns 220A each is connected with the first light emitting element 151, for example, the first light emitting element 151 overlaps with the pixel driving circuit 120 and is directly connected with the pixel driving circuit 120 through a via hole connection structure; a part of the second the pixel driving circuits 120 in each of the plurality of pixel driving columns 220B each is connected with the second light emitting element 152 through one of the plurality of anode connection lines 140, so that a part of the pixel driving circuits 120 located in the normal display region 114 can drive the second light emitting elements 152 located in the transparent display region 112 to emit light. It should be noted that, in order to clearly illustrate the pixel driving circuit and various signal lines under the first light emitting element, FIG. 1 only illustrates one first light emitting element and two second light emitting elements, the embodiments of the present disclosure include but not limited thereto, each of the pixel driving circuits in each of the plurality of first pixel driving columns can be provided with a first light emitting element correspondingly, and the transparent display region can be provided with a plurality of second light emitting elements according to required parameters such as brightness, resolution, transmittance, etc.

As illustrated by FIG. 1, the display substrate 100 further includes a first transfer line 171 and a second transfer line 172, the first transfer line 171 extends in the first direction X, and the second transfer line 172 extends in the second direction Y, the first transfer line 171 and the second transfer line 172 are arranged in different layers, the first transfer line 171 and the second transfer line 172 are connected with the cathode of the first light emitting element 151 and are configured to transmit a first power voltage, such as a VSS voltage; the first transfer line 171 is connected with the second transfer line 172 through a first via hole connection structure V1, an orthographic projection of the first via hole connection structure V1 on the base substrate 110 do not overlap with an orthographic projection of the plurality of anode connection lines 140 on the base substrate 110. For example, as illustrated by the line frame 290 in FIG. 1, the orthographic projection of the first via hole connection structure V1 on the base substrate 110 do not overlap with the orthographic projection of the plurality of anode connection lines 140 on the base substrate 110.

In the display substrate provided by the embodiments of the present disclosure, because the display substrate includes the transparent display region, the transparent display region can be correspondingly provided with a photosensitive device such as a camera, so that the display substrate can realize the full display with camera (FDC) design. In addition, because the first transfer line and the second transfer line for transmitting the first power voltage are connected with each other through the first via hole connection structure, the display substrate can reduce the load of the first transfer line and the second transfer line, so that the uniformity of the first power voltage signal on the entire display substrate is relatively high, thereby improving the display image quality. On the other hand, because the orthographic projection of the first via hole connection structure on the base substrate does not overlap with the orthographic projection of the plurality of anode connection lines on the base substrate, the display substrate can further avoid the risk of disconnection of the anode connection line caused by a recessed structure formed by the first via hole connection structure.

For example, the material of the base substrate 110 may be a transparent material such as glass, plastic, quartz, or a silicon-based semiconductor material. Of course, the embodiments of the present disclosure include but are not limited thereto, and the material of the base substrate may further be other suitable materials.

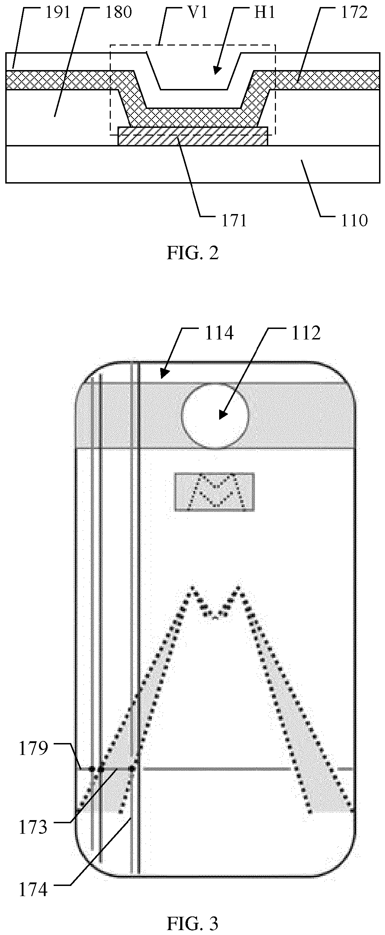

FIG. 2 is a schematic diagram of the connection between a first transfer line and a second transfer line in a display substrate provided by an embodiment of the present disclosure. As illustrated by FIG. 2, an insulating planarization layer 180 is provided between the first transfer line 171 and the second transfer line 172; in this case, the first via hole connection structure V1 includes a first via hole H1 located in the planarization layer 180, the first via hole H1 exposes a part of the first transfer line 171; a part of the second transfer line 172 is located in the first via hole H1 and connected with the first transfer line 171.

As illustrated by FIG. 2, an insulating layer 191 is further provided on a side of the second transfer line 172 away from the planarization layer 180; because of the existence of the first via hole connection structure V1, a recessed structure will form at a position of the insulating layer 191 corresponding to the first via hole connection structure V1, and in the case where the anode connection line overlaps with the first via hole connection structure, the risk of the anode connection line being disconnected at the position of the recessed structure will easily occur, thus making the second light emitting element located in the transparent display region cannot emit light. In the display substrate provided by the embodiment of the present disclosure, because the orthographic projection of the first via hole connection structure on the base substrate does not overlap with the orthographic projection of the plurality of anode connection lines on the base substrate, the display substrate can further avoid the risk of disconnection of the anode connection line caused by the recessed structure formed by the first via hole connection structure, and the product yield can be improved.

For example, the planarization layer 180 may include one of an organic planarization layer and an inorganic planarization layer or a stacked structure thereof; the material of the organic planarization layer may be at least one of polyimide, resin, and acrylic; the material of the inorganic planarization layer may be at least one of silicon oxide, silicon nitride or silicon oxynitride. The material of the passivation layer may be at least one of silicon oxide, silicon nitride, or silicon oxynitride. Of course, the embodiments of the present disclosure include but are not limited thereto, and the planarization layer can further be made of other materials.

For example, the material of the insulating layer 191 may be one or more of silicon oxide, silicon nitride, and silicon oxynitride. Of course, the embodiments of the present disclosure include but are not limited thereto, and the material of the insulating layer can further be other materials.

In some examples, as illustrated by FIG. 1, the base substrate 110 further includes a peripheral region 118 surrounding the normal display region 114; the display substrate 100 further includes a power voltage line 260 located in the peripheral region 118, the power voltage line 260 is configured to transmit the first supply voltage. At least one of the first transfer line 171 and the second transfer line 172 extends to the peripheral region 118 and is electrically connected with the power voltage line 260.

In some examples, as illustrated by FIG. 1, the plurality of first transfer lines 171 and the plurality of second transfer lines 172 can form a grid structure through a plurality of first via hole connection structures V 1, thereby further reducing the load and improving the uniformity of the first power voltage on the entire display substrate, and improving the display image quality.

In some examples, as illustrated by FIG. 1, the display substrate 100 further includes a third transfer line 173 and a fourth transfer line 174; both of the third transfer line 173 and the fourth transfer line 174 are located in the normal display region 114; the third transfer line 173 extends in the first direction X, and the fourth transfer line 174 extends in the second direction Y; one end of the third transfer line 173 is connected with the data line 130, and the other end of the third transfer line 173 is connected with the fourth transfer line 174. Therefore, the display substrate can arrange the leading lines of the data lines in the normal display region to reduce the size of the leading line region (Fan-out region), or even eliminate the leading line region to achieve a narrow frame design.

In some examples, as illustrated by FIG. 1, the display substrate 100 further includes a peripheral region 118 surrounding the normal display region 114. The fourth transfer line 174 extends from the normal display region 114 to the peripheral region 118 to lead out the data line 130 through the third transfer line 173. It should be noted that the fourth transfer line can directly extend to the peripheral region and be connected with a driving IC that provides the data signal; of course, the embodiments of the present disclosure include but are not limited thereto, the fourth transfer line can further extend to the peripheral region by changing layers and be connected with the driving IC that provides the data signal, and the position of changing layers can be outside the normal display region.

In some examples, as illustrated by FIG. 1, the third transfer line 173 is arranged in the same layer as the first transfer line 171. It should be noted that the above-mentioned "arranged in the same layer" means that the third transfer line and the first transfer line are formed from the same conductive layer through the same patterning process.

In some examples, as illustrated by FIG. 1, the fourth transfer line 174 and the second transfer line 172 are arranged in the same layer. It should be noted that the above-mentioned "arranged in the same layer" means that the fourth transfer line and the second transfer line are formed from the same conductive layer through the same patterning process.

In some examples, although the third transfer line 173 and the first transfer line 171 may be arranged in the same layer, the first transfer line 171 is configured to transmit the first power voltage, and the third transfer line 173 is configured to transmit the data signal. Similarly, although the fourth transfer line 174 and the second transfer line 172 may be arranged in the same layer, the second transfer line 172 is configured to transmit the first power voltage, and the fourth transfer line 174 is configured to transmit the data signal.

In some examples, as illustrated by FIG. 1, the display substrate 100 further includes a connection line segment 179, the connection line segment 179 and the third transfer line 173 are arranged in the same layer and are insulated from each other; both of the connection line segment 179 and the third transfer line 173 overlap with a straight line extending in the direction X, and the connection line segment 179 connects the plurality of second transfer lines 172 arranged in the first direction X. Because the third transfer line is configured to connect the data line to the corresponding fourth transfer line, third transfer line cannot extend from one edge of the normal display region to the other edge. In this case, in the first direction, in the case where the third transfer line exists in a part of the normal display region, and no third transfer line exists in another part of the normal display region, it is easy to cause the third transfer line to be seen by the user when the display substrate is not lit, which affects the display quality. However, in the display substrate, by arranging the connection line segment and making the connection line segment and the third connecting line be substantially located on a straight line extending in the first direction X, the display substrate can prevent the third connecting line from being noticed by the user. On the other hand, the connection line segment can further reduce the overall load of the first transfer line and the second transfer line.

FIG. 3 is a schematic plan view of another display substrate provided by an embodiment of the present disclosure. As illustrated by FIG. 3, the third transfer line 173 can be located in an M-shaped region as illustrated by FIG. 3, by arranging the above-mentioned connection line segment 179, the connection line segment 179 and the third transfer line 173 can have the same light reflectivity, thereby preventing the third transfer line from being noticed by the user. It should be noted that the third transfer line can further be located in a V-shaped region, a W-shaped region, a triangular region, etc. in the normal display region, and the embodiments of the present disclosure are not limited thereto.

In some examples, as illustrated by FIG. 1, the connection line segment 179 and the third transfer line 173 are arranged in the same layer and are arranged at intervals in the first direction. That is to say, the connection line segment 179 and the third transfer line 173 can be formed from the same conductive layer through the same patterning process, so that the connection line segment 179 and the third transfer line 173 can have the same light reflectivity, thereby preventing the third transfer line from being noticed by the user.

In some examples, as illustrated by FIG. 1, a distance between the connection line segment 179 and the third transfer line 173 in the first direction is smaller than a size of one pixel driving circuit 130 in the first direction, thereby preventing the distance from being noticed by the user. It should be noted that the size of the above-mentioned pixel driving circuit in the first direction may be the size of the orthographic projection of film layers in the pixel driving circuit on the base substrate in the first direction, or may be the size of the orthographic projection of an active layer of the pixel driving circuit on the base substrate in the first direction.

In some examples, the orthographic projection of the space between the connection line segment and the third transfer line on the base substrate may overlap with the orthographic projection of the anode of the light emitting element on the base substrate to further make the space cannot be noticed by the user, which further improves the display quality.

In some examples, as illustrated by FIG. 1, a width of the connection line segment 179 in the second direction is equal to a width of the third transfer line 173 in the second direction, thereby further preventing the third transfer line from being noticed by the user.

In some examples, as illustrated by FIG. 1, in at least one pixel driving column 220, both of the second transfer line 172 and the fourth transfer line 174 overlap with a virtual straight line extending in the second direction Y and are insulated from each other. Therefore, by making the second transfer line and the fourth transfer line to be approximately located on a virtual straight line extending in the second direction, the display substrate can prevent the second transfer line and the fourth transfer line from being noticed by the user.

In some examples, as illustrated by FIG. 1, in at least one pixel driving column 220, the second transfer line 172 and the fourth transfer line 174 are arranged in the same layer and at intervals in the first direction. That is to say, the second transfer line 172 and the fourth transfer line 174 can be formed from the same conductive layer through the same patterning process, so that the second transfer line 172 and the fourth transfer line 174 have the same light reflectivity, thereby preventing the second transfer line 172 and the fourth transfer line 174 from being noticed by the user.

In some examples, as illustrated by FIG. 1, a distance between the second transfer line 172 and the fourth transfer line 174 in the second direction is smaller than a size of one pixel driving circuit 130 in the second direction, thereby preventing the distance from being noticed by the user.

In some examples, as illustrated by FIG. 1, a width of the second transfer line 172 in the first direction is equal to a width of the fourth transfer line 174 in the first direction, thereby further preventing the second transfer line and the fourth transfer line from noticed by the user.

In some examples, as illustrated by FIG. 1, the normal display region 114 includes a first sub-display region 114A and a second sub-display region 114B arranged in the first direction, and the data line 130 located at the edge of the first sub-display region 114A is connected with the fourth transfer line 174 located in the first sub-display region 114A through the third transfer line 173, the data line 130 located at the edge of the second sub-display region 114B is connected with the fourth transfer line 174 in the second sub-display region 114B through the third transfer line 173. With this arrangement, the display substrate can gather the leading lines of the data lines in the normal display region to realize the function of the leading lines. Of course, the embodiments of the present disclosure include but are not limited thereto. The above-mentioned first sub-display region and second sub-display region may not be provided, and the data line at the edge of the normal display region may be connected with the fourth transfer line located in the normal display region through the third transfer line.

In some examples, as illustrated by FIG. 1, one second pixel driving column 220B is inserted into every three first pixel driving columns 220A, that is, two first pixel driving columns 220A are provided between two adjacent second pixel driving columns 220B. Of course, the embodiments of the present disclosure include but are not limited thereto, one second pixel driving column can be inserted into every two first pixel driving columns, and one second pixel driving column can be inserted into every four first pixel driving columns; that is, one first pixel driving column, three first pixel driving columns, or four first pixel driving columns are arranged between two adjacent second pixel driving columns.

In some examples, one second pixel driving column is inserted into every N first pixel driving columns, and the value of N ranges from 2 to 10.

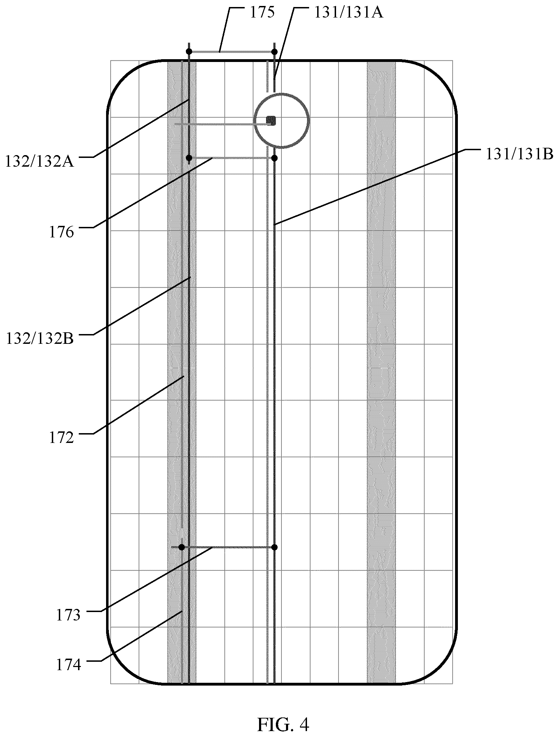

FIG. 4 is a schematic plan view of another display substrate provided by an embodiment of the present disclosure. As illustrated by FIG. 1 and FIG. 4, the plurality of data lines 130 include a first data line 131 and a second data line 132, the first data line 131 is connected with the first pixel driving column 220A and is disconnected in the transparent display region 112 to form a first sub-data line segment 131A and a second sub-data line segment 131B. The second data line 132 is connected with the second pixel driving column 220B and includes a third sub-data line segment 132A and a fourth sub-data line segment 132B, an orthographic projection of the third sub-data line segment 132A on a reference straight line extending in the second direction Y covers an orthographic projection of the transparent display region 112 on the reference straight line. That is to say, the first data line 131 is disconnected by the transparent display region 112 and forms the first sub-data line segment 131A and the second sub-data line segment 131B, the second data line 132 is disconnected at a lower junction position between the transparent display region 112 and the normal display region 114 and forms a third sub-data line segment 132A and a fourth sub-data line segment 132B. It should be noted that, in order to clearly illustrate the connection relationship between the above-mentioned signal lines or signal line segments, FIG. 3 only illustrates some of the signal lines and some of signal line segments.

As illustrated by FIG. 1 and FIG. 4, because the fourth sub-data line segment 132B does not need to drive the light emitting element, the fourth sub-data line segment 132B does not need to be loaded with the data signal, in this case, the fourth sub-data line segment 132B can be electrically connected with the first transfer line 171 and loaded with the first power voltage to reduce the load of the first transfer line 171.

As illustrated by FIG. 1 and FIG. 4, the display substrate 100 further includes a fifth transfer line 175 and a sixth transfer line 176, the fifth transfer line 175 is located at a first side of the transparent display region 112 in the second direction, the sixth transfer line 176 is located at a second side of the transparent display region 112 in the second direction, the first sub-data line 131A is connected with the third sub-data line segment 132A through the fifth transfer line 175, and the second sub-data line 131B is connected with the third sub-data line segment 132A through the sixth transfer line 176. Therefore, the display substrate can connect the first sub-data line and the second sub-data line separated by the transparent display region through the fifth transfer line and the sixth transfer line to realize signal transmission. Moreover, the third sub-data line can be configured as a data line of the pixel driving circuit corresponding to the second light emitting element in the transparent display region, and the first sub-data line, the third sub-data line and the second sub-data line are connected with each other to provide the data signals to the light emitting elements located in the same column in the display substrate.

In some examples, as illustrated by FIG. 1 and FIG. 4, the fifth transfer line 175 and the sixth transfer line 176 are arranged in the same layer as the first transfer line 171, thereby the fifth transfer line 175, the sixth transfer line 176 and the first transfer line 171 can be made to have the same reflectivity of light while making better use of the conductive film layer on the display substrate, thereby preventing the fifth transfer line 175, the sixth transfer line 176 and the first transfer line 171 from being noticed by the user. Of course, the embodiments of the present disclosure include but are not limited thereto, and the fifth transfer line and the sixth transfer line can further be provided on other conductive layers.

In some examples, as illustrated by FIG. 1 and FIG. 4, both of the sixth transfer line 176 and the first transfer line 171 overlap with a virtual straight line extending in the first direction X, so that the sixth transfer line 176 and the first transfer line 171 can be further avoided to be noticed by the user.

In some examples, as illustrated by FIG. 1 and FIG. 4, a width of the sixth transfer line 176 in the second direction Y is equal to a width of the first transfer line 171 in the second direction Y, so that the sixth transfer line 176 and the first transfer line 171 can be further avoided to be noticed by the user.

In some examples, as illustrated by FIG. 1 and FIG. 4, the fourth sub-data line segment 132B is connected with the first transfer line 171 through the second via hole connection structure V2. Because the pixel driving circuit 120 corresponding to the fourth sub-data line segment 132B is not actually configured to drive the light emitting element, which is a dummy pixel driving circuit, the fourth sub-data line 132B does not need to transmit the data signal. In this case, the fourth sub-data line segment is connected with the first transfer line through the second via hole connection structure, the fourth sub-data line segment can further be configured to reduce the load of the first transfer line and the second transfer line, and improve the display quality. It should be noted that the specific structure of the second via hole connection structure can be referred to the first via hole connection structure, and will not be described again here.

In some examples, as illustrated by FIG. 1 and FIG. 4, the base substrate 110 further includes a peripheral region 118 surrounding the normal display region 114, and the fifth transfer line 175 is located in the peripheral region 118. Therefore, the display substrate can use the space of the peripheral region to arrange the fifth transfer line, thereby improving the space utilization of the display substrate and reducing the number of signal lines in the display region.

In some examples, as illustrated by FIG. 1 and FIG. 4, the fifth transfer line 175 and the sixth transfer line 176 may be arranged in the same layer. However, the embodiments of the present disclosure include but are not limited thereto. Because few various signal lines exist in the peripheral region, the fifth transfer line and the sixth transfer line can further be arranged in different layers and made of other conductive layers.

In some examples, as illustrated by FIG. 4, the second sub-data line segment 131B can further be transferred to the fourth transfer line 174 through the third transfer line 173, and the fourth transfer line 174 extends from the normal display region 114 to the peripheral region.

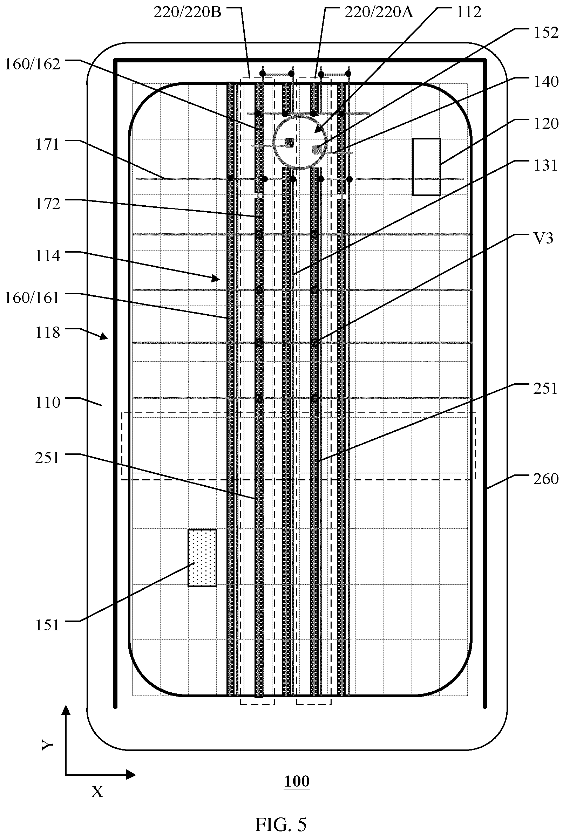

FIG. 5 is a schematic plan view of another display substrate provided by an embodiment of the present disclosure. As illustrated by FIG. 5, the display substrate 100 includes a base substrate 110, a plurality of pixel driving circuits 120, a plurality of data lines 130 and a plurality of anode connection lines 140; the base substrate 110 includes a transparent display region 112 and a normal display region 114 surrounding the transparent display region 112; the transparent display region 112 and the normal display region 114 constitute a display region for light emitting display. A plurality of pixel driving circuits 120 are located in the normal display region 114 and are arranged in an array along the first direction X and the second direction Y to from a plurality of pixel driving rows 210 and a plurality of pixel driving columns 220, each of the plurality of pixel driving rows 210 extends in the first direction X, and each of the plurality of pixel driving columns 220 extends in the second direction Y; the plurality of data lines 130 extend in the second direction Y and are configured to provide data signals to the plurality of pixel driving columns 220.

As illustrated by FIG. 5, the normal display region 114 includes a first light emitting element 151, the transparent display region 112 includes a second light emitting element 152, and the plurality of pixel driving columns 220 includes a plurality of first pixel driving columns 220A and a plurality of second pixel driving columns 220B; the pixel driving circuits 120 in each of the plurality of first pixel driving columns 220A each is connected with the first light emitting element 151, for example, the first light emitting element 151 overlaps with the pixel driving circuit 120 and is directly connected with the pixel driving circuit 120 through a via hole connection structure; a part of the pixel driving circuits 120 in the pixel driving column 220B each is connected with the second light emitting element 152 through one of the plurality of anode connection lines 140, so that a part of the pixel driving circuits 120 located in the normal display region 114 can drive the light emitting elements 152 located in the transparent display region 112 to emit light. It should be noted that the sizes of the first light emitting element and the second light emitting element are only illustrative, and the size of the first light emitting element may be smaller than the size of the second light emitting element.

As illustrated by FIG. 5, the display substrate 100 further includes a first transfer line 171 and a second transfer line 172, the first transfer line 171 extends in the first direction X, and the second transfer line 172 extends in the second direction Y, the first transfer line 171 and the second transfer line 172 are arranged in different layers, the first transfer line 171 and the second transfer line 172 are connected with the cathode of the first light emitting element 151 and are configured to transmit the first power voltage, such as VSS; the first transfer line 171 and the second transfer line 172 are connected with each other through the first via hole connection structure V1, an orthographic projection of the first via hole connection structure V1 on the base substrate 110 does not overlaps an orthographic projection of the plurality of anode connection lines 140 on the base substrate 110.

In the display substrate provided by the embodiments of the present disclosure, because the display substrate includes the transparent display region, the transparent display region can be correspondingly provided with a photosensitive device such as a camera, so that the display substrate can realize the full display with camera (FDC). In addition, because the first transfer line and the second transfer line for transmitting the first power voltage are connected with each other through the first via hole connection structure, the display substrate can reduce the load of the first transfer line and the second transfer line, so that the uniformity of the first power voltage signal on the entire display substrate is relatively high, thereby improving the display image quality. On the other hand, because the orthographic projection of the first via hole connection structure on the base substrate does not overlap with the orthographic projection of the plurality of anode connection lines on the base substrate, the display substrate can further avoid the risk of disconnection of the anode connection line caused by a recessed structure formed by the first via hole connection structure.

In some examples, as illustrated by FIG. 5, the display substrate 100 further includes a plurality of power lines 160 and a first conductive structure 251; the plurality of power lines 160 extend in the second direction and are configured to provide a second power voltage to the plurality of pixel driving columns 220, such as VDD; the first conductive structure 251 is arranged in the same layer as the plurality of power lines 160; an orthographic projection of the first conductive structure 251 on the base substrate 110 overlaps an orthographic projection of a pixel driving circuit 120 in one of the plurality of second pixel driving columns 220B on the base substrate 110 that is not connected with the anode connection line 140, and the first conductive structure 251 is connected with the first transfer line 171 through the third via hole connection structure V3. Because the pixel driving circuits 120 in the second pixel driving column 220B that are not connected with the anode connection line 140 do not actually need to drive the light emitting elements for light emitting display, the parts of these pixel driving circuits corresponding to the power lines, that is, the first conductive structures can be configured to transmit the first power voltage, thereby further reducing the load on the first transfer line and the second transfer line and improving the display quality.

In some examples, as illustrated by FIG. 5, the plurality of power lines 160 include a first power line 161 and a second power line 162; the first power line 161 is arranged corresponding to the first pixel driving column 220A and is configured to provide the second power voltage to the pixel driving circuit 120 in the first pixel driving column 220A. It should be noted that the first power line may be electrically connected with the anode of the first light emitting element, or the anode of the first light emitting element may be configured to apply the second power voltage through the pixel driving circuit.

In some examples, as illustrated by FIG. 5, an orthographic projection of the second power line 162 on a reference straight line extending in the second direction covers an orthographic projection of the transparent display region 112 on the reference straight line.

In some examples, an orthographic projection of the second power line 162 on the base substrate 110 overlaps an orthographic projection of at least one anode connection line 140 on the base substrate 110.

In some examples, as illustrated by FIG. 5, each of some of the first power lines 161 is further divided into two sub-first power line segments by the transparent display region 112.

In some examples, as illustrated by FIG. 5, a length of the second power line 162 is less than a length of the first power line 161; both of the second power line 162 and the first conductive structure 251 overlap with a virtual straight line extending in the second direction Y; the second power line 162 and the first conductive structure 251 are arranged in the same layer, that is, the second power line 162 and the first conductive structure 251 are formed from the same conductive layer through the same patterning process. Because the pixel driving circuit corresponding to the first conductive structure is not actually configured to drive the light emitting element and is a dummy pixel driving circuit, the first conductive structure does not need to transmit the second power voltage. In this case, the first conductive structure can be configured to transmit the first power voltage, thereby further reducing the load on the first transfer line and the second transfer line and improving the display quality.

In some examples, as illustrated by FIG. 5, the width of the second power line 162 in the first direction is equal to the width of the first conductive structure 251 in the first direction.

In some examples, as illustrated by FIG. 5, the power line 160 is located on the base substrate 110, the first transfer line 171 may be located at a side of the power line 160 away from the base substrate 110, and the second transfer line 172 may be located at a side of the first transfer line 171 away from the base substrate 110.

In some examples, as illustrated by FIG. 5, the anode connection line 140 may be located at a side of the second transfer line 172 away from the base substrate 110.

In some examples, the power line 160 may be located in a first conductive layer or a first source-drain metal layer on the base substrate 110; the first transfer line 171, the third transfer line 173, the connection line segment 179, the fifth transfer line 175 and the sixth transfer line 176 may be located in a second conductive layer or a second source-drain metal layer located at a side of the first conductive layer away from the base substrate 110; the second transfer line 172 and the fourth transfer line 174 may be located in the third conductive layer or the third source-drain metal layer located at a side of the second conductive layer away from the first conductive layer.

In some examples, the first conductive layer, the second conductive layer and the third conductive layer can be made of metal materials; the anode connection line can be made of transparent conductive oxide.

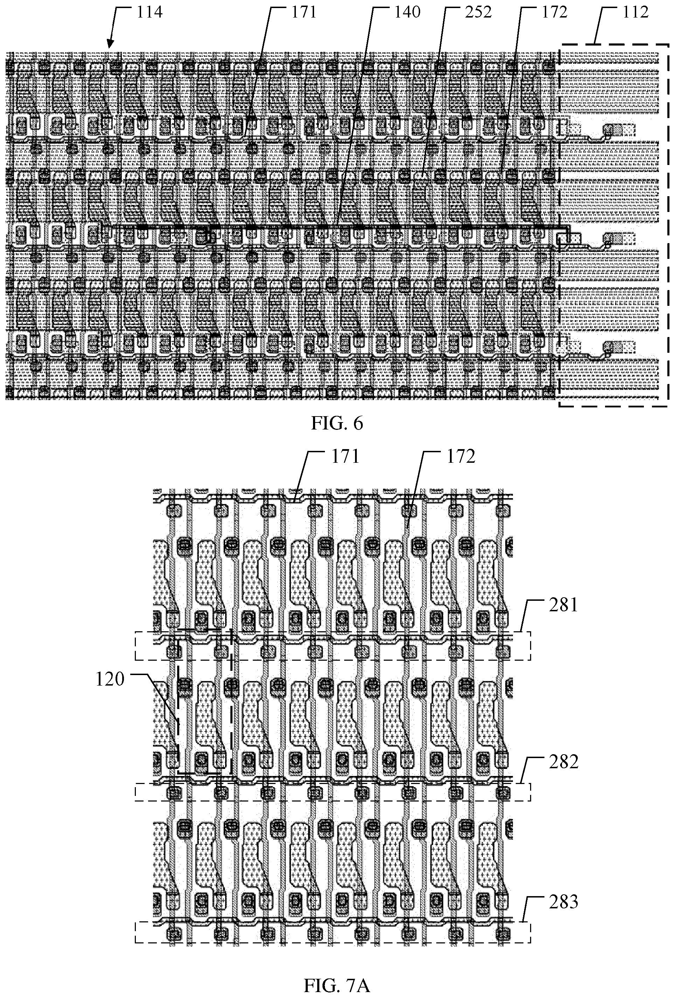

FIG. 6 is a schematic diagram of a stacked structure of a display substrate provided by an embodiment of the present disclosure. As illustrated by FIG. 6, some of the pixel driving circuits 120 located in the normal display region 114 are connected with a plurality of anode connection lines 140, and the plurality of anode connection lines 140 extend from the normal display region 114 to the transparent display region 112, to provide a driving voltage for the second light emitting element in the transparent display region 112.

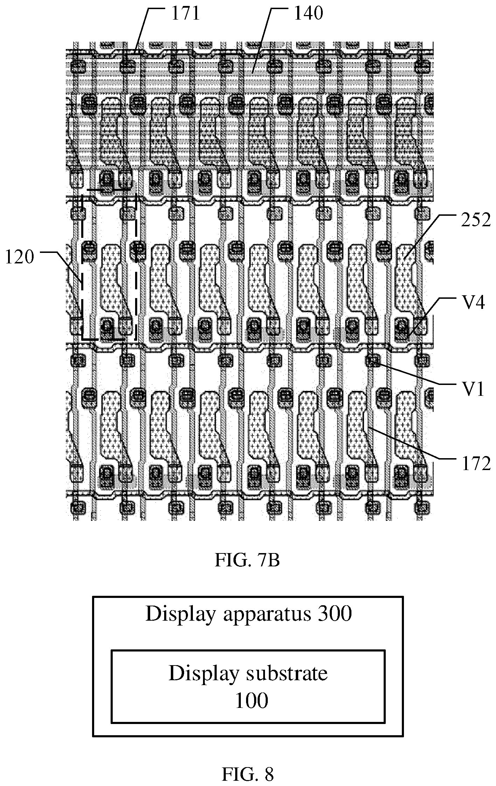

FIG. 7A is a schematic diagram of a stacked structure of another display substrate provided by an embodiment of the present disclosure; FIG. 7B is a schematic diagram of a stacked structure of another display substrate provided by an embodiment of the present disclosure. FIG. 7A illustrates a schematic diagram of a stacked structure of a region provided with anode connection lines, for the sake of clarity, the anode connection lines are omitted; FIG. 7B illustrates a schematic diagram of a stacked structure of a region provided with anode connection lines and a region without anode connection line.

As illustrated by FIG. 7A and FIG. 7B, in the region where the anode connection line 140 is provided, the first transfer line 171 and the second transfer line 172 are not connected with each other through the via hole connection structure; while in the region where the anode connection line 140 is not provided, the first transfer line 171 and the second transfer line 172 are connected with each other through the via hole connection structure. That is to say, the first transfer line 171 and the second transfer line 172 are connected with each other through the first via hole connection structure V1, and the orthographic projection of the first via hole connection structure V1 on the base substrate 110 does not overlap with the orthographic projection of the plurality of anode connection lines 140 on the base substrate 110. Therefore, the display substrate can further avoid the risk of disconnection of the anode connection line caused by a recessed structure formed by the first via hole connection structure.

As illustrated by FIG. 7B, each pixel driving circuit 120 includes a second conductive structure 252; the second conductive structure 252 is arranged in the same layer as the first transfer line 171; the second conductive structure 252 in the pixel driving circuit 120 in the second pixel driving column 220B that is not connected with the anode connection line 140 is connected with the second transfer line 172 through the fourth via hole connection structure V4. Because the pixel driving circuits 120 in the second pixel driving column 220B that are not connected with the anode connection lines 140 do not actually need to drive the light emitting elements for light emitting display, the second conductive structures in these pixel driving circuits can be configured to transmit the first power voltage, thereby further reducing the load on the first transfer line and the second transfer line, and improving the display quality.

An embodiment of the present disclosure further provides a display apparatus. FIG. 8 is a schematic diagram of a display apparatus provided by an embodiment of the present disclosure. As illustrated by FIG. 8, the display apparatus 300 includes the above-mentioned display substrate 100. Therefore, the display apparatus can achieve a narrow frame design and the full display with camera design. In addition, the display apparatus can further reduce the load of the first power voltage and improve the display quality.

For example, in some examples, the display apparatus can be any product or component with a display function, such as a smartphone, a tablet computer, a television, a monitor, a notebook computer, a digital photo frame, a navigator, or the like.

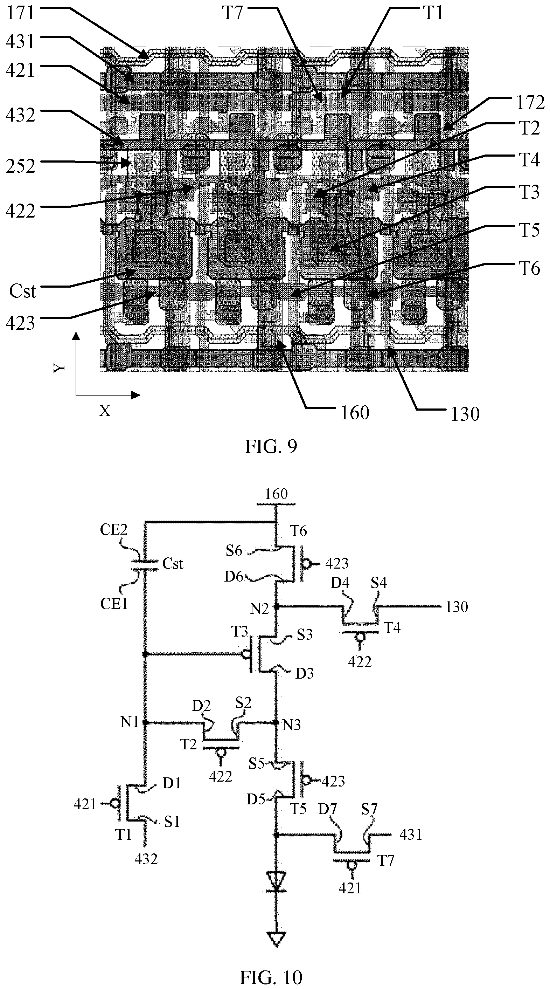

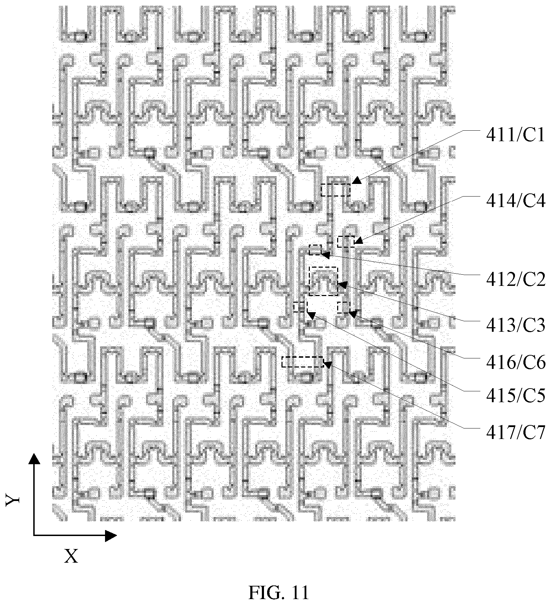

An embodiment of the present disclosure provides a display substrate. FIG. 9 is a schematic diagram of a stacked structure of a display substrate provided by an embodiment of the present disclosure; FIG. 10 is an equivalent schematic diagram of a pixel driving circuit in a display substrate provided by an embodiment of the present disclosure; and FIG. 11-FIG. 16 are schematic diagrams of a plurality of film layers in a display substrate provided by an embodiment of the present disclosure.

As illustrated by FIG. 9 to FIG. 16, the display substrate 100 includes a base substrate 110, a semiconductor layer 410, a first gate layer 420, a second gate layer 430, a first conductive layer 440, a second conductive layer 450 and a third conductive layer 460. The semiconductor layer 410, the first gate layer 420, the second gate layer 430, the first conductive layer 440, the second conductive layer 450 and the third conductive layer 460 are sequentially arranged in a direction perpendicular to the base substrate 110. It should be noted that an insulating layer, such as a gate insulating layer, an interlayer insulating layer or a passivation layer, etc. is provided between any two of the semiconductor layer, the first gate layer, the second gate layer, the first conductive layer, the second conductive layer and the third conductive layer, which will not be described again here.

In the display substrate provided by the embodiment of the present disclosure, the pixel driving circuit may adopt a 7T1C structure, that is, a circuit structure including seven transistors and a storage capacitor. Of course, the embodiments of the present disclosure include but are not limited thereto, and the pixel driving circuit may further adopt other types of circuit structures, such as 8T1C, 8T2C, etc.

In the following, the plurality of film layers of the display substrate provided by the embodiment of the present disclosure will be described in detail with reference to FIG. 9- FIG. 16 by taking that the pixel driving circuit adopts the 7T1C structure as an example.

As illustrated by FIG. 9 and FIG. 10, the pixel driving circuit 120 includes a first transistor T1, a second transistor T2, a third transistor T3, a fourth transistor T4, a fifth transistor T5, a sixth transistor T6, a seventh transistor T7 and a storage capacitor Cst. The drain electrode of the first transistor T1, the drain electrode of the second transistor T2 and the gate electrode of the first transistor T1 are connected with the first node N1, the source electrode of the third transistor T3, the drain electrode of the fourth transistor T4 and the drain electrode of the sixth transistor T6 are connected with the second node N2, the drain electrode of the third transistor T3, the source electrode of the fifth transistor T5 and the source electrode of the second transistor T2 are connected with the third node, the drain electrode of the fifth transistor T5 and the drain electrode of the seventh transistor T7 are connected with the anode of the light emitting element (such as the above-mentioned first light emitting element or the second light emitting element); the first electrode plate CE1 of the storage capacitor Cst and the gate electrode of the third transistor T3 are connected with the first node N1, and the second electrode plate CE2 of the capacitor storage Cst is connected with the source electrode of the sixth transistor T6 and is configured to be connected with a power line.

In some examples, as illustrated by FIG. 9 and FIG. 11, the semiconductor layer 410 includes a first unit 411, a second unit 412, a third unit 413, a fourth unit 414, a fifth unit 415, a sixth unit 416 and a seventh unit 417. The first unit 411 includes a first channel region C 1 and a first source region S1 and a first drain region D1 located at both sides of the first channel region C1, the second unit 412 includes a second channel region C2 and a second source region S2 and a second drain region S2 located at both sides of the second channel region C2, the third unit 413 includes a third channel region C3 and a third source region S3 and a third drain region D3 located at both sides of the third channel region C3, the fourth unit 414 includes a fourth channel region C4 and a fourth source region S4 and a fourth drain region D4 located at both sides of the fourth channel region C4, the fifth unit 415 includes a fifth channel region C5 and a fifth source region S5 and a fifth drain region S5 located at both sides of the fifth channel region C5, the sixth unit 416 includes a sixth channel region C6 and a sixth source region S6 and a sixth drain region D6 located at both sides of the sixth channel region C6, the seventh unit 417 includes a seventh channel region C7 and a seventh source region S7 and a seventh drain region D7 located at both sides of the seventh channel region C7.

For example, the semiconductor layer may be made of silicon-based semiconductor material, such as polysilicon. Of course, the embodiments of the present disclosure include but are not limited thereto, the semiconductor layer may further adopt other semiconductor materials such as oxide semiconductor materials.

It should be noted that each of the above-mentioned channel regions may be an undoped part of the semiconductor layer, and each of the source region and drain region may be a doped part of the semiconductor layer. In addition, the above-mentioned first unit 411 is the active layer of the first transistor T1, the above-mentioned second unit 412 is the active layer of the second transistor T2, the above-mentioned third unit 413 is the active layer of the third transistor T3, the above-mentioned fourth unit 414 is the active layer of the fourth transistor T4, the above-mentioned fifth unit 415 is the active layer of the fifth transistor T5, the above-mentioned sixth unit 416 is the active layer of the sixth transistor T6, and the above-mentioned seventh unit 417 is the active layer of the seventh transistor T7.

For example, as illustrated by FIG. 11, the first drain region D1 and the second drain region D2 are connected with each other, the second source region S2, the third drain region D3 and the fifth source region S5 are connected with each other, the fourth drain region D4, the third source region S3 and the sixth drain region D6 are connected with each other, and the fifth drain region D5 and the seventh drain region D7 are connected with each other.

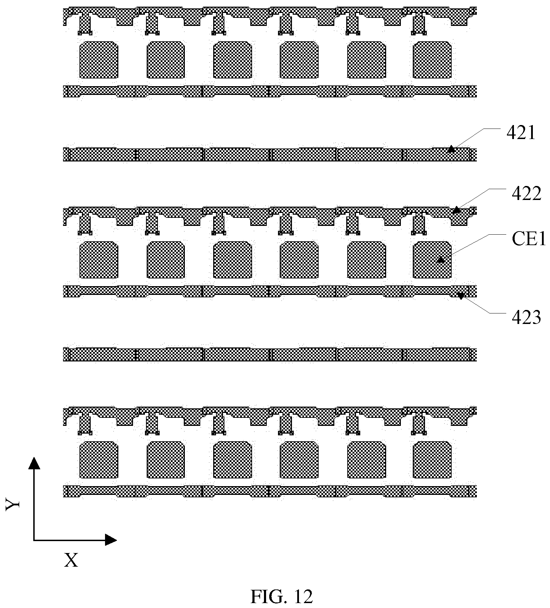

In some examples, as illustrated by FIG. 12, the first gate electrode layer 420 includes a reset signal line 421 extending in the first direction, a gate line 422 extending in the first direction, a first electrode block CE1 and a light emitting control line 423 extending in the first direction.

For example, as illustrated by FIG. 9- FIG. 16, the reset signal line 421 overlaps with the seventh channel region C7 and the first channel region C1 of the semiconductor layer 410, so that a portion of the reset signal line 421 overlapping with the seventh channel region C7 and a portion of the reset signal line 421 overlapping with the first channel region C1 can respectively serve as the gate electrode of the seventh transistor T7 and the gate electrode of the first transistor T1. The gate line 422 overlaps with the second channel region C2 and the fourth channel region C4 of the semiconductor layer 410, so that a portion of the gate line 422 overlapping with the second channel region C2 and a portion of the gate line 422 overlapping with the fourth channel region C4 can respectively serve as the gate electrode of the second transistor T2 and the gate electrode of the fourth transistor T4. The light emitting control line 423 overlaps with the fifth channel region C5 and the sixth channel region C6, so that a portion of the light emitting control line 423 overlapping with the fifth channel region C5 and a portion of the light emitting control line 423 overlapping with the sixth channel region C6 can respectively serve as the gate electrode of the fifth transistor T5 and the gate electrode of the sixth transistor T6. The first electrode block CE1 overlaps with the third channel region C3, so that the first electrode block CE1 can serve as the gate electrode of the third transistor T3.

For example, as illustrated by FIG. 12, the reset signal line 421, the gate line 422 and the light emitting control line 423 all extend generally in the first direction; the reset signal line 421, the gate line 422, the first electrode block CE1 and the light emitting control line 423 are arranged sequentially in the second direction perpendicular to the first direction.

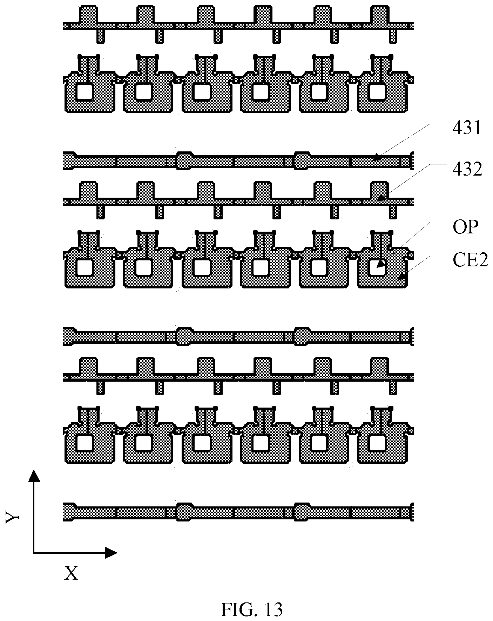

In some examples, as illustrated by FIG. 13, the second gate layer 430 includes a first initialization signal line 431, a second initialization signal line 432 and a second electrode block CE2 extending in the first direction. The first initialization signal line 431, the second initialization signal line 432 and the second electrode block CE2 are arranged sequentially in the second direction.

For example, as illustrated by FIG. 9- FIG. 16, the first initialization signal line 431 is electrically connected with the first source region S1 and the seventh source region S7, thereby providing an initialization signal to the first transistor T1 and the seventh transistor T7. An orthographic projection of the second electrode block CE2 on the base substrate 110 at least partially overlaps with an orthographic projection of the first electrode block CE1 on the base substrate 110 to form the storage capacitor Cst.

For example, as illustrated by FIG. 13, the second electrode block CE2 includes an opening OP, and an orthographic projection of the opening OP on the base substrate 110 overlaps with an orthographic projection of the first electrode layer CE1 on the base substrate 110 to expose a part of the first electrode block CE1.

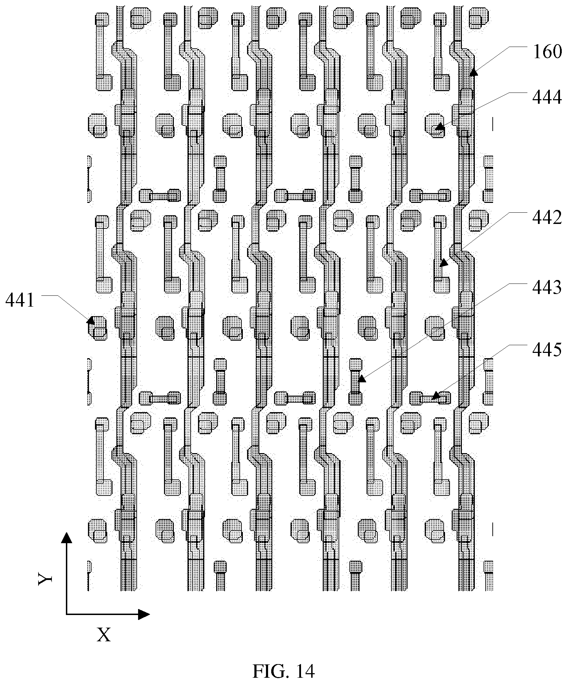

In some examples, as illustrated by FIG. 14, the first conductive layer 440 includes a power line 160 extending in the second direction, a first transfer block 441, a second transfer block 442, a third transfer block 443, a fourth transfer block 444 and fifth transfer block 445.

For example, as illustrated by FIG. 9-FIG. 16, the first transfer block 441 is connected with the fifth drain region D5 of the fifth transistor T5 and is configured to be connected with the anode of the subsequently formed light emitting element, thereby transmitting the driving signal (for example, the power voltage) from the fifth source region D5 of the fifth transistor T5 to the anode of the light emitting element.

For example, as illustrated by FIG. 9 to FIG. 16, one end of the second transfer block 442 is connected with the first drain region D1 of the first transistor T 1, and the other end of the second transfer block 442 can pass through the opening OP and be connected with the gate electrode of the third transistor T3, that is, be connected with the first electrode block CE1. In this case, the second transfer block can further be regarded as a node connecting block of the first node N1.

For example, as illustrated by FIG. 9 to FIG. 16, one end of the third transfer block 443 is connected with the seventh source region D7 of the seventh transistor T7, and the other end of the third transfer block 443 is connected with the first initialization signal line 431, thereby connecting the first initialization signal line 431 with the source electrode of the seventh transistor T7.

For example, as illustrated by FIG. 9-FIG. 16, the fourth transfer block 444 is connected with the fourth source region S4 of the fourth transistor T4, and is configured to be connected with a subsequently formed data line, thereby transmitting the data signal to the fourth source region S4 of the fourth transistor T4.

For example, as illustrated by FIG. 9 to FIG. 16, one end of the fifth transfer block 445 is connected with the sixth source region S6 of the sixth transistor T6, and the other end of the fifth transfer block 445 is connected with the second initialization signal line 432, thereby connecting the second initialization signal line 432 with the source electrode of the sixth transistor T6.

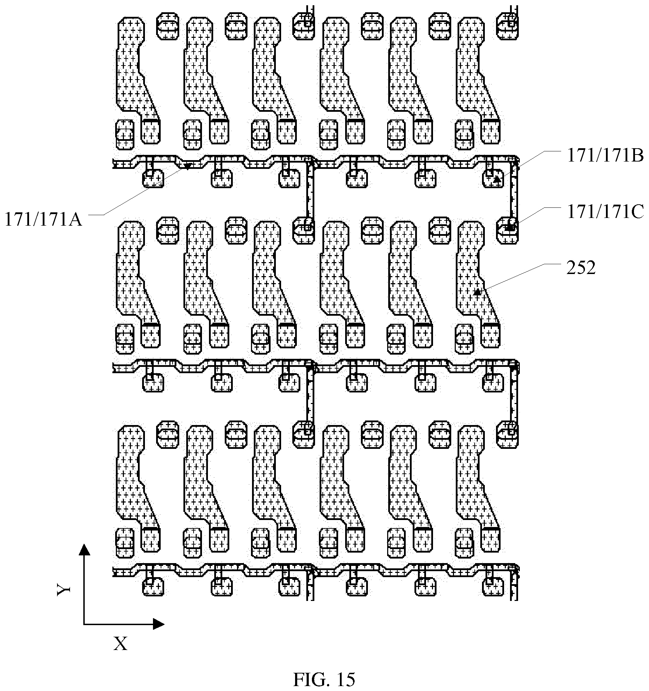

In some examples, as illustrated by FIG. 15, the second conductive layer 450 includes the above-mentioned first transfer line 171 and the second conductive structure 252; the first transfer line 171 includes a main body portion 171A extending in the first direction and a first extension portion 171B and a second extension portion 171C extending from the main body portion 171A in the second direction; the first extension portion 171B is configured to be electrically connected with the subsequently formed second transfer line 172, and is a position where the first connecting via hole structure is located. The second extension portion 171C is located only in the second pixel driving column 220B and is configured to be electrically connected with the subsequently formed fourth sub-data line segment 132B.

For example, as illustrated by FIG. 15, the second conductive structure 252 in the first pixel driving column 220A may be electrically connected with the power line 160, while the second conductive structure 252 of the pixel driving circuit 120 in the second pixel driving column 220B that is not connected with the anode connection line 140 is connected with the second transfer line 172 through the fourth via hole connection structure V4.

For example, as illustrated by FIG. 9 and FIG. 15, an orthographic projection of the second conductive structure 252 on the base substrate 110 overlaps with an orthographic projection of the second transfer block 442 on the base substrate 110, so that the voltage on the first node N1 is more stable.

For example, as illustrated by FIG. 9 and FIG. 15, an orthographic projection of the second conductive structure 252 on the base substrate 110 overlaps with an orthographic projection of the second transfer line 172 on the base substrate.

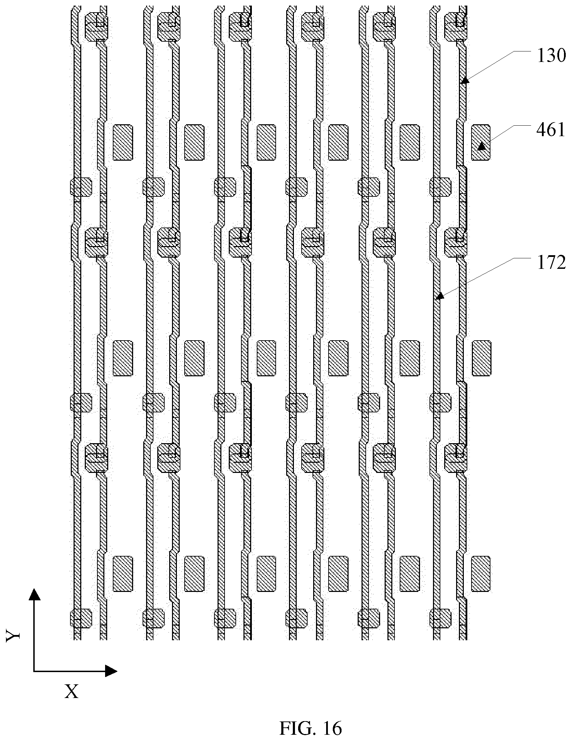

In some examples, as illustrated by FIG. 16, the third conductive layer 460 includes the data line 130, the second transfer line 172 and a connecting electrode 461. The data line 130 is electrically connected with the fourth transfer block 444, the second transfer line 172 is electrically connected with the first transfer line 171, and the connecting electrode 461 is electrically connected with the first transfer block 441.

A working mode of the pixel driving circuit illustrated in FIG. 10 will be schematically described below. First, in the case where a reset signal is transmitted to the reset signal line 421 and the seventh transistor T7 is turned on, the residual current flowing through the anode of each light emitting element is discharged through the seventh transistor T7, so that the light emitting caused by the residual current flowing through the anode of each light emitting element can be suppressed. Then, in the case where the reset signal is transmitted to the reset signal line 421, the first initialization signal is transmitted to the first initialization signal line 431, and the second initialization signal is transmitted to the second initialization signal line 432, the first transistor T1 and the seventh transistor T7 are turned on, the first initialization signal initializes the anode of each light emitting element through the seventh transistor T7, the second initialization signal initializes the gate electrode of the third transistor T3 and the first electrode block CE1 of the storage capacitor Cst through the first transistor T 1, and the third transistor T3 can be turned on in the case where the gate electrode of the third transistor T3 is initialized.

Subsequently, in the case where the gate signal is transmitted to the gate line 422 and the data signal is transmitted to the data line 130, both the second transistor T2 and the fourth transistor T4 are turned on, and the data line 130 applies a data voltage Vd to the gate electrode of the third transistor T3 through the second transistor T2 and the fourth transistor T4. In this case, the voltage applied to the gate electrode of the third transistor T3 is a compensation voltage Vd+Vth, and the compensation voltage applied to the gate electrode of the third transistor T3 is also applied to the first electrode block CE1 of the storage capacitor Cst.

Subsequently, the power line 160 applies a driving voltage Vel to the second electrode block CE2 of the storage capacitor Cst, and applies the compensation voltage Vd+Vth to the first electrode block CE1, so that the electric charge corresponding to the difference between voltages respectively applied to the two electrodes of the storage capacitor Cst is stored in the storage capacitor Cst, and the third transistor T3 is turned on for a predetermined time.

Subsequently, in the case where the light emitting control signal is applied to the light emitting control line 423, both the sixth transistor T6 and the fifth transistor T5 are turned on, so that the power line 160 applies the driving voltage Vel to the source electrode of the sixth transistor T6, in this case, when the driving voltage Vel passes through the third transistor T3 turned on by the storage capacitor Cst, the voltage of the drain electrode of the third transistor T3 is Vel, and the voltage of the gate electrode of the third transistor T3 is Vd+Vth, which can make the third transistor T3 in a saturate state, so that the third transistor T3 generates driving current Ids; then, the driving current Id is applied to the anode electrode of the light emitting element through the fifth transistor T5, so that the light emitting element emits light.

It should be noted that the above-mentioned working mode of the driving circuit is only one possible driving mode of the driving circuit, and the embodiments of the present disclosure include but are not limited thereto.

In some examples, the first conductive layer may be a first source-drain metal layer, the second conductive layer may be a second source-drain metal layer, and the third conductive layer may be a third source-drain metal layer.

The following points need to be explained:
(1) In the drawings of the embodiment of the present disclosure, only the structure related to the embodiment of the present disclosure is involved, and other structures can refer to the general design.
(2) Features in the same embodiment and different embodiments of the present disclosure can be combined with each other without conflict.

The above is only the specific embodiment of the present disclosure, but the protection scope of the present disclosure is not limited thereto. Any person familiar with the technical field can easily think of changes or substitutions within the technical scope disclosed in the present disclosure, and they should be included in the protection scope of the present disclosure. Therefore, the scope of protection of the present disclosure should be based on the scope of protection of the claims.

## Claims

1. A display substrate, comprising:
a base substrate, comprising a transparent display region and a normal display region surrounding the transparent display region;
a plurality of pixel driving circuits, located in the normal display region and arranged in an array along a first direction and a second direction to form a plurality of pixel driving rows and a plurality of pixel driving columns, each of the plurality of pixel driving rows extending in the first direction, each of the plurality of pixel driving columns extending in the second direction;
a plurality of data lines, extending in the second direction and configured to provide data signals to the plurality of pixel driving columns;
a plurality of anode connection lines,
wherein the normal display region comprises a first light emitting element, the transparent display region comprises a second light emitting element, the plurality of pixel driving columns comprises a plurality of first pixel driving columns and a plurality of second pixel driving columns, and pixel driving circuits in each of the plurality of first pixel driving columns each is connected with the first light emitting element, and a part of pixel driving circuits in each of the plurality of second pixel driving columns each is connected with the second light emitting element through one of the plurality of anode connection lines;
the display substrate further comprises a first transfer line and a second transfer line, the first transfer line extends in the first direction, the second transfer line extends in the second direction, the first transfer line and the second transfer line are arranged in different layers, and the first transfer line and the second transfer line are connected with a cathode of the first light emitting element and are configured to transmit a first power voltage,
the first transfer line is connected with the second transfer line through a first via hole connection structure, and an orthographic projection of the first via hole connection structure on the base substrate does not overlap with an orthographic projection of the plurality of anode connection lines on the base substrate.

2. The display substrate according to claim 1, wherein the display substrate further comprises a third transfer line and a fourth transfer line, the third transfer line and the fourth transfer line are located in the normal display region, the third transfer line extends in the first direction, and the fourth transfer line extends in the second direction,
one end of the third transfer line is connected with the data line, and the other end of the third transfer line is connected with the fourth transfer line.

3. The display substrate according to claim 2, wherein the third transfer line and the first transfer line are arranged in the same layer.

4. The display substrate according to claim 2, wherein the fourth transfer line and the second transfer line are arranged in the same layer.

5. The display substrate according to claim 2, further comprising:
a connection line segment, arranged in the same layer as the third transfer line and insulated with the third transfer line,
wherein both of the connection line segment and the third transfer line overlap with a virtual straight line extending in the first direction, and the connection line segment connects a plurality of second transfer lines arranged in the first direction.

6. The display substrate according to claim 2, wherein in at least one of the plurality of pixel driving columns, both of the second transfer line and the fourth transfer line overlap with a virtual straight line extending in the second direction, and the second transfer line and the fourth transfer line are insulated from each other.

7. The display substrate according to any one of claims 2 to 6, wherein the normal display region comprises a first sub-display region and a second sub-display region arranged in the first direction, the data line located at an edge of the first sub-display region is connected with the fourth transfer line located in the first sub-display region through the third transfer line, and the data line located at an edge of the second sub-display region is connected with the fourth transfer line located in the second sub-display region through the third transfer line.

8. The display substrate according to any one of claims 1 to 7, wherein two first pixel driving columns are arranged between two adjacent second pixel driving columns.

9. The display substrate according to any one of claims 1 to 8, wherein the plurality of data lines comprise a first data line and a second data line, and the first data line is connected with one of the plurality of first pixel driving columns and is disconnected in the transparent display region to form a first sub-data line segment and a second sub-data line segment, the second data line is connected with one of the plurality of second pixel driving columns and comprises a third sub-data line segment and a fourth sub-data line segment, an orthographic projection of the third sub-data line segment on a reference straight line extending in the second direction covers an orthographic projection of the transparent display region on the reference straight line,
the display substrate further comprises a fifth transfer line and a sixth transfer line, the fifth transfer line is located at a first side of the transparent display region in the second direction, the sixth transfer line is located at a second side of the transparent display region in the second direction, the first sub-data line is connected with the third sub-data line segment through the fifth transfer line, and the second sub-data line is connected with the third sub-data line segment through the sixth transfer line.

10. The display substrate according to claim 9, wherein the fifth transfer line and the sixth transfer line are arranged in the same layer as the first transfer line.

11. The display substrate according to claim 9, wherein the fourth sub-data line segment is connected with the first transfer line through a second via hole connection structure.

12. The display substrate according to claim 9, wherein the base substrate further comprises a peripheral region surrounding the normal display region, and the fifth transfer line is located in the peripheral region.

13. The display substrate according to any one of claims 1-12, further comprising:
a plurality of power lines, extending in the second direction and configured to provide a second power voltage to the plurality of pixel driving columns; and
a first conductive structure, arranged in the same layer as the plurality of power lines,
wherein an orthographic projection of the first conductive structure on the base substrate overlaps with an orthographic projection of a pixel driving circuit in one of the plurality of second pixel driving columns that is not connected with the plurality of anode connection lines on the base substrate, the first conductive structure is connected with the first transfer line through a third via hole connection structure.

14. The display substrate according to any one of claims 1 to 13, wherein each of the plurality of pixel driving circuits comprises a second conductive structure arranged in the same layer as the first transfer line;
the second conductive structure in the pixel driving circuit in the second pixel driving column that is not connected with the anode connection line is connected with the second transfer line through a fourth via hole connection structure.

15. The display substrate according to any one of claims 1 to 14, wherein the base substrate further comprises a peripheral region surrounding the normal display region, and the display substrate further comprises a power voltage line located in the peripheral region, the power voltage line is configured to transmit the first power voltage;
at least one of the first transfer line and the second transfer line extends to the peripheral region and is electrically connected with the power voltage line.

16. A display apparatus, comprising the display substrate according to any one of claims 1-15.
